# EUROPÄISCHE PATENTANMELDUNG

(11) **EP 0 650 065 A2**
(43) Veröffentlichungstag der Anmeldung: **26.04.1995**
(21) Anmeldenummer: 94116483.2
(22) Anmeldetag: 19.10.1994
(51) Int. Cl.: G01R 1/073, G01R 31/28

(54) **Vakuumadapter**

(30) Priorität: 20.10.1993 DE 4335841
(71) Anmelder: Siemens Nixdorf Informationssysteme AG, D-33106 Paderborn (DE)
(72) Erfinder: Sulka, Richard, Dipl.-Ing. (FH), D-89284 Pfaffenhofen/Beuren (DE); Weigel, Hermann, Dipl.-Ing. (FH), D-86391 Stadtbergen (DE); Bredl, Frank, D-86199 Augsburg/Bergham (DE)
(74) Vertreter: Fuchs, Franz-Josef, Dr.-Ing.

(57) **Zusammenfassung**

Die Erfindung bezieht sich auf einen Vakuumprüfadapter zum Kontaktieren von zu prüfenden Elektronikflachbaugruppen mit einer Prüfeinrichtung. Dabei wird auf einen einseitigen Prüfadapter eine weitere Adaptiereinheit (3) aufgesetzt, so daß eine doppelseitige Vakuumadaptierung erfolgen kann.

## Beschreibung

Die Erfindung betrifft einen Vakuumadapter zum Kontaktieren von mit einer Prüfeinrichtung zu prüfenden Elektronikflachbaugruppen, dessen Boden aus einer mit Rasterlöchern versehenen Schnittstellenplatte besteht, die mit einem Rahmen, der erste Vakuumschlitze enthält, umgeben ist, auf dem eine erste Kontaktträgerplatte mit zweiten Vakuumschlitzen aufliegt, die sowohl in die Rasterlöcher der Schnittstellenplatte hineinragende Anschlußkontaktstifte, als auch nach oben und unten herausragende Prüfnadeln enthält, die mit den Anschlußkontaktstiften elektrisch verbunden sind, wobei diese erste Kontaktträgerplatte zusammen mit einer Andruckplatte und einer zwischen beiden an der Peripherie umlaufenden ersten Dichtung eine erste Vakuumkammer bildet, wobei die ersten und zweiten Vakuumschlitze einen Zuführungskanal zur Vakuumkammer bilden, und wobei die zu prüfenden Elektronikflachbaugruppen über die zweite Dichtung auf die Andruckplatte auflegbar sind.

Aus dem HP 3070 Test Fixture Product Catalog, April 1989, Seiten 2 und 3, ist ein einseitig kontaktierender Vakuumprüfadapter bekannt. Er besteht aus einem Unterbau mit einer Schnittstellenplatte einer ersten Kontaktträgerplatte, einer Andruckplatte und der dazwischenliegenden Dichtung. Diese drei Komponenten bilden eine Unterdruckkammer, die bei Erzeugung eines Unterdrucks die auf der Andruckplatte aufliegende Elektronikflachbaugruppe an die Adapternadeln der ersten Kontaktträgerplatte andrückt, wodurch eine Kontaktierung mit den Prüfpunkten auf der Elektronikflachbaugruppe erfolgt, z.B. Katalog 1992, Seite 12, Prüfadapter, Zubehör, Dienstleistungen der Firma Ingun.

Auch doppelseitige Vakuumadapter sind bekannt. Diese sind bisher jedoch nur für eine relativ kleine Fläche einsetzbar und besitzen kein genügend genaues Führungssystem zur Erreichung der erforderlichen Genauigkeit. Der Aufbau erfolgt meist mit Vollhaube, so daß zusätzliche Niederhalter erforderlich sind. Außerdem besteht dabei keine Möglichkeit der Prüflingskühlung und keine Zugänglichkeit der Baugruppe für das Prüfprogrammdebugging. Sie sind bezüglich maximaler Prüflungsgröße und minimaler Prüfpunktgröße auf Grund ihres Aufbaus stark limitiert.

Aufgabe der vorliegenden Erfindung ist es, einen doppelseitigen Vakuumadapter zu schaffen, mit einer hohen Genauigkeit der Kontaktierung der Adapternadeln mit den Prüfpunkten der Elektronikbaugruppe.

Zur Lösung dieser Aufgabe wird der Vakuumprüfadapter derart ausgebildet, daß an den Stirnseiten der Andruckplatte dritte jeweils zweite Vakuumkammern abgrenzende, Dichtungen angeordnet sind, die zusammen mit einer zweiten Kontaktträgerplatte, die sowohl Prüfnadeln, als auch Anschlußkontaktstifte, die über Verdrahtungen miteinander verbunden sind, und die mit einer Deckplatte abgedeckt sind, enthält, und daß die Andruckplatte dritte Vakuumschlitze enthält, die mit den zweiten Vakuumschlitzen der unteren Kontaktträgerplatte kongruent sind.

Durch diese Maßnahmen erhält man einen Vakuumadapter, mit dem auf beiden Seiten des Prüflings hohe Kontaktgenauigkeiten erreicht werden können.

Vorteilhafterweise kann die zweite Kontaktträgerplatte in einem aufklappbaren Rahmen befestigt sein. Die Deckplatte ist zweckmäßig aus durchsichtigem Material, wie z.B. Plexiglas. Zur Erreichung eines genügend genauen Führungssystems ist es außerdem vorteilhaft, daß auf der ersten Kontaktträgerplatte an ihren vier Ecken je eine Führungseinheit befestigt ist, die jweils aus einem Führungsstift besteht, der durch eine in der Andruckplatte befindlichen Buchse geführt ist, und der an seinem oberen Ende eine mit einer Handschraube gesicherte Führungshülse mit Außenkonus enthält, die mittels einer an der Andruckplatte abestützten Gegendruckfeder nach oben gedrückt wird, und daß fluchtend zum Führungsstift in der zweiten Kontaktträgerplatte ein Führungsflansch befestigt ist, der beim Schließen mit seinem Innenkonus in den Außenkonus der Führungsstifte eingreift.

Außerdem kann auf der zweiten Kontaktträgerplatte ein vakuumdichter Führungsdeckel angeordnet sein, der eine Ausnehmung enthält, in die der Führungsstift nach dem Schließvorgang einfährt.

Anhand des bekannten einseitigen Vakuumprüfadapters nach Figur 1, sowie der Ausführungsbeispiele nach den Figuren 2 bis 4, wird die Erfindung näher erläutert.

Es zeigen
Figur 1 einen bekannten einseitigen Adapter,
Figur 2 den doppelseitigen Adapter nach der Erfindung,
Figur 3 die Führungseinheit,
Figur 4 eine Seitenansicht mit Schnittdetails des doppelseitigen Adapters in drei unterschiedlichen Klapphasen.

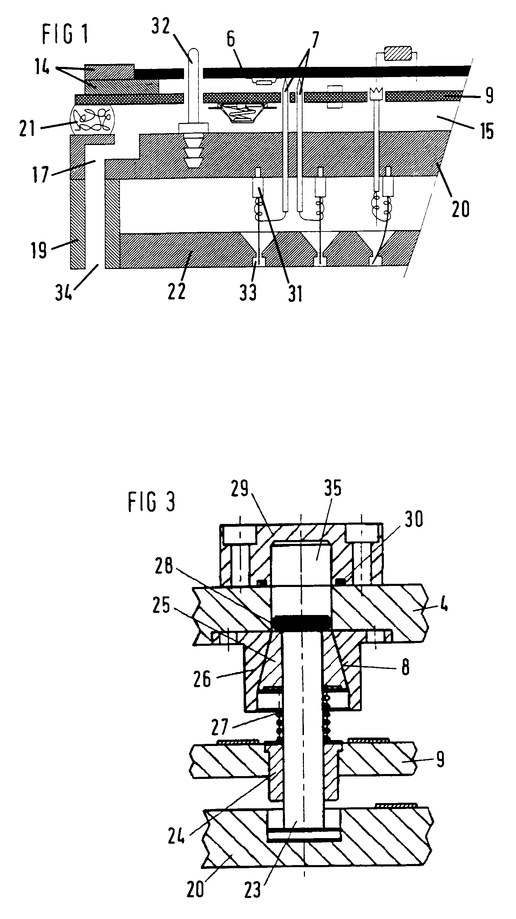

Der einseitige Adapter nach Figur 1 besteht aus der Schnittstellenplatte 22, dem rundum verlaufenden Rahmen 19 mit den ersten Vakuumschlitzen 34, der diesem Rahmen aufgesetzten ersten Kontaktträgerplatte 20 mit den zweiten Vakuumschlitzen 17, sowie den auf ihr angeordneten Anschlußkontaktstiften 31, die in die Rasterlöcher 33 der Schnittstellenplatte 22 hineinragen und den Prüfnadeln 7, die an ihrer Unterseite mit den Anschlußkontaktstiften 31 elektrisch verbunden sind. Die Prüfnadeln 7 ragen durch die Andruckplatte 9 hindurch, die auf einer rundum auf der ersten Kontaktträgerplatte 20 verlaufenden ersten Dichtung 21 aufgesetzt ist. Die erste Kontaktträgerplatte 20 bildet zusammen mit der ersten Dichtung 21 und der Andruckplatte 9 die erste Vakuumkammer 15 und die ersten Schlitze 34 und die zweiten Schlitze 17 ergeben zusammen den die erste Vakuumkammer 15 mit der äußeren Umgebung verbindenden Kanal, über den das Vakuum herstellbar ist. Auf einer zweiten Dichtung 14, die auf der Andruckplattenoberfläche ebenfalls rundum verläuft, liegt dann die zu prüfenden Elektronikflachbaugruppe 6 auf. Wird in der ersten Vakuumkammer 15 ein Vakuum erzeugt, so wird die Elektronikflachbaugruppe 6 an den vorgesehenen Pads mit den Prüfnadeln 7 kontaktiert und über die an den Anschlußkontaktstiften 31 der Schnittstellenplatte 22 angeschlossenen Prüfvorrichtung kann nunmehr die Prüfung der Elektronikflachbaugruppe 6 erfolgen.

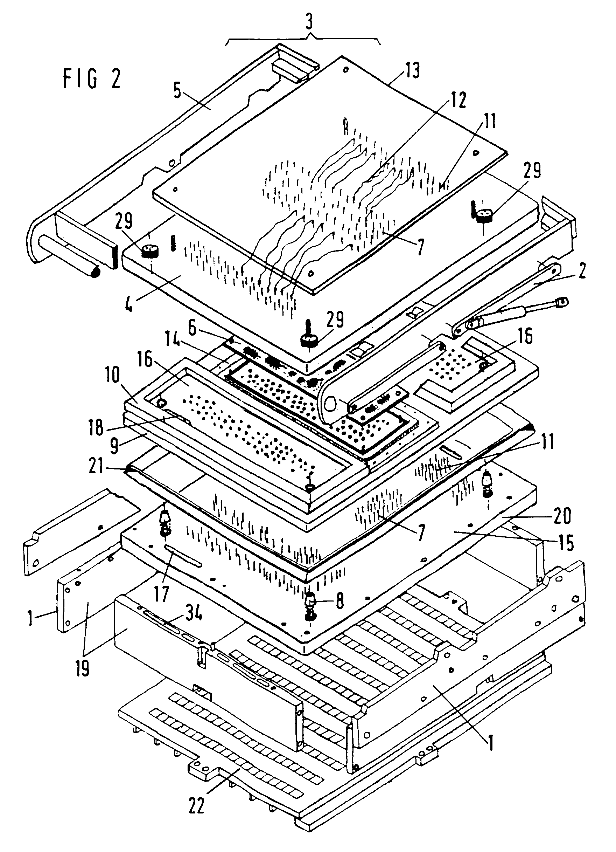

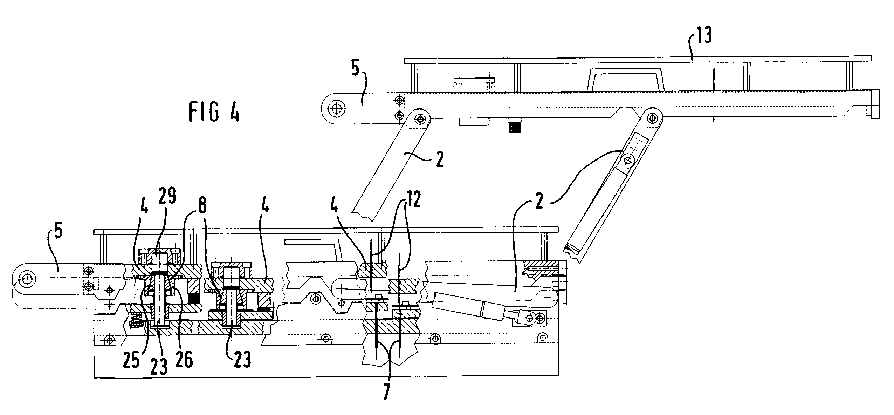

Die Explosionszeichnung nach Figur 2 zeigt wiederum die Schnittstellenplatte 22, sowie die rundum verlaufenden Rahmen 19 mit den ersten Vakuumschlitzen 34, und die erste Kontaktträgerplatte 20 mit den Prüfnadeln 7 und den Führungseinheiten 8. Zwischen der Andruckplatte 9 und der ersten Kontaktträgerplatte 20 ist die erste Dichtung 21, die ein V-förmiges Profil aufweist, ersichtlich. Ebenfalls auf der ersten Kontaktträgerplatte sind die zweiten Vakuumschlitze 17 zu sehen. Oberhalb dieser Andruckplatte 9 beginnt nun die obere Adaptereinheit 3 für den doppelseitigen Betrieb, d.h. die Elektonikbaugruppen 9 können sowohl von unten, als auch von oben mit den Prüfnadeln 7 kontaktiert werden. Der Aufbau beginnt mit den unteren Rahmenleisten 1, welche links und rechts am Rahmen 19 angeschraubt sind. Diese Rahmenleisten 1 verbinden mittels Gelenkstäben 2 die obere Adaptiereinheit 3, bestehend aus den Elementen: Zweite Kontaktträgerplatte 4 mit der elektrischen Verdrahtung 12, oberer Rahmen 5 zum Aufklappen, sowie die daran festmontierten Elemente, wie z.B. die Plexiglasplatte 13 mit dem Rahmen 5. Damit die obere Adaptiereinheit 3 bzw. die darin liegende zweite Kontaktträgerplatte 4 nach Einlegen der Elektronikbaugruppe 6 deckungsgleich mit den von unten kontaktierenden Prüfnadeln 7 ist, muß eine in Figur 3 näher beschriebene Führungseinheit 8 die zweite Kontaktträgerplatte 4 fangen und führen. Die Vakuum-betätigung wird durch zwei eingebaute zweite Vakuumkammern 16 ermöglicht, welche sich nach Schließen der oberen Adaptiereinheit 3 zwischen der Andruckplatte 9 und der zweiten Kontaktträgerplatte 4 bilden. Der Vakuumanschluß der einzelnen zweiten Vakuumkammern erfolgt über die ersten Vakuumschlitze 34, die zweiten Vakuumschlitze 17 und die dritten, in der Andruckplatte 9 befindlichen Vakuumschlitze 18. Die dritten Dichtungen 10 zwischen der Andruckplatte 9 und der zweiten Kontaktträgerplatte 4, welche die zweiten Vakuumkammern 16 begrenzen, werden so verlegt, daß die Schnittstellennadeln 11 zur Signalübergabe im Vakuum liegen. Sie sind dabei an der vorderen und hinteren Frontseite der Andruckplatte 9 angeordnet. Über die zweite Baugruppendichtung 14, die zwischen den beiden zweiten Vakuumkammern 16 angeordnet ist, wird die Elektronikflachbaugruppe 6 auf die Andruckplatte 9 aufgelegt.

Die Funktion des doppelseitig vakuumbetriebenen Nadeladapters ist wie folgt: Nach dem Einlegen der Elektronikflachbaugruppe 6 in die zweite Dichtung 14, wird die obere Adaptiereinheit 3 auf die Elektronikflachbaugruppe 6 hin geschlossen. Die zweite Dichtung 14 ist auf der Andruckplatte 9 festgeklebt. Nun wird Vakuum appliziert. Durch den wirkenden Unterdruck in den ersten und zweiten Vakuumkammern 15, 16 wird die gesamte Anordnung wie ein Sandwich zusammengedrückt. Die obere Adaptiereinheit 3 bewegt sich dabei auf die Elektronikflachbaugruppe 6 zu. Die Flachbaugruppe 6 wird dabei von den oberen Prüfnadeln 7, welche in der zweiten Kontaktträgerplatte 4 eingebettet sind, kontaktiert. Dem hingegen bewegt sich die fest auf der Andruckplatte 9 fixierte Elektronikflachbaugruppe 6 auf die erste Kontaktträgerplatte 20 zu. Dabei wird die Elektronikflachbaugruppe 6 von den in der ersten Kontaktträgerplatte 20 eingebetteten unteren Prüfnadeln 7 kontaktiert. Damit kann die elektrische Prüfung der Flachbaugruppe beginnen.

Die Führungseinheit 8 ist, wie in Figur 3 dargestellt, aufgebaut. Auf dem Führungsstift 23, verschraubt in der ersten Kontaktträgerplatte 20, sind die Andruckplatte 9 und die zweite Kontaktträgerplatte 4 aufgefädelt. Um die Andruckplatte 9 in möglichst engen Toleranzen zu führen, sind Führungsbuchsen 24 in die Andruckplatte 9 eingesetzt. Die Schnittstelle beim Öffnen und Schließen der oberen Adaptiereinheit 3 bildet die Führungshülse 25 mit Außenkonus und der Führungsflansch 26 mit Innenkonus. Damit die Führungshülse 25 mit Außenkonus beim Schließvorgang den an der zweiten Kontaktträgerplatte 4 befestigten Führungsflansch 26 auch fängt und zentriert, wird diese durch die Gegendruckfeder 27 nach oben gehalten. Gesichert ist diese Anordnung durch die Handschraube 28. Die Konusform an beiden Führungselementen 25, 26 läßt größere Fluchtungsabweichungen (Fangtoleranzen) beim Schließen der oberen Adaptiereinheit 3 bzw. der oberen Kontaktträgerplatte 4 zu. Der Führungsdeckel 29 mit eingebautem Dichtring 30 schließt das System vakuumdicht ab. Die obere Adaptiereinheit 3 wird auf Grund der beiden zweiten Vakuumkammern 16, welche sich jeweils neben der Flachbaugruppe 6 und zwischen der Andruckplatte 9 und der zweiten Kontaktplatte 4 befinden, angesaugt. Vorteilhaft ist die Anordnung der zweiten Dichtungen 10 und die Möglichkeit, Schnittstellenandeln 11 innerhalb der Vakuumkammern 16 zu plazieren. Die Schnittstellennadeln 11 übertragen die von oben abgegriffenen Testsignale zum Testsystem. Die zweiten Dichtungen 10 können rechteckige Schaumstoffprofildichtungen sein.

Das Zusammenspiel der oberen Adaptiereinheit 3 mit dem unteren Adapterteil zeigt Figur 4 in unterschiedlichen Stellungen. In der ersten Stellung ist die obere Adaptiereinheit völlig aufgeklappt. Man erkennt den oberen Rahmen 5, sowie die Plexiglasabdeckung 13 und die Gelenkstäbe 2. In der zuzweiten Stellung ist ein Zustand gezeigt, bei dem die Führungselemente 25 und 26 bereits ineinander verschoben sind. Rechts daneben ist dann die dritte Stellung angedeutet, bei der die obere Adaptiereinheit vollkommen eingeschwenkt ist und der Prüfzustand erreicht ist. Die zweite und dritte Stellung sind auch im Bereich der Prüfnadeln 7 und der Schnittstellennadeln 11 weiter rechts in der Figur dargestellt.

## Patentansprüche

1. Vakuumadapter zum Kontaktieren von mit einer Prüfeinrichtung zu prüfenden Elektronikflachbaugruppen, dessen Boden aus einer mit Rasterlöchern versehenen Schnittstellenplatte besteht, die mit einem Rahmen, der erste Vakuumschlitze enthält, umgeben ist, auf dem eine erste Kontaktträgerplatte mit zweiten Vakuumschlitzen aufliegt, die sowohl in die Rasterlöcher der Schnittstellenplatte hineinragende Anschlußkontaktstifte, als auch nach oben und unten herausragende Prüfnadeln enthält, die mit den Anschlußkontaktstiften elektrisch verbunden sind, wobei diese erste Kontaktträgerplatte zusammen mit einer Andruckplatte und einer zwischen beiden an der Peripherie umlaufenden ersten Dichtung eine erste Vakuumkammer bildet, wobei die ersten und zweiten Vakuumschlitze einen Zuführungskanal zur Vakuumkammer ergeben, und wobei die zu prüfenden Elektronikflachbaugruppen über eine zweite Dichtung auf die Andruckplatte auflegbar sind,
**dadurch gekennzeichnet,**
daß an den Stirnseiten der Andruckplatte (9) dritte, jeweils zweite Vakuumkammern abgrenzende, Dichtungen (10) angeordnet sind, die zusammen mit einer zweiten Kontaktträgerplatte (4), die sowohl Prüfnadeln (7), als auch Anschlußkontaktstifte (33), die über Verdrahtungen (12) miteinander verbunden sind, und die mit einer Deckplatte (13) abgedeckt sind enthält, und daß die Andruckplatte (9) dritte Vakuumschlitze (18) enthält, die mit den zweiten Vakuumschlitzen (34) der ersten Kontaktträgerplatte kongruent sind.

2. Vakuumadapter zum Kontaktieren von zu prüfenden Elektronikflachbaugruppen mit einer Prüfeinrichtung nach Anspruch 1,
**dadurch gekennzeichnet,**
daß die zweite Kontaktträgerplatte (4) in einem aufklappbaren Rahmen (5) befestigt ist.

3. Vakuumadapter zum Kontaktieren von zu prüfenden Elektronikflachbaugruppen mit einer Prüfeinrichtung nach Anspruch 1,
**dadurch gekennzeichnet,**
daß die Deckplatte (13) aus durchsichtigem Material, wie z.B. Plexiglas besteht.

4. Vakuumadapter zum Kontaktieren von zu prüfenden Elektronikflachbaugruppen mit einer Prüfeinrichtung nach einem der vorhergehenden Ansprüche,
**dadurch gekennzeichnet,**
daß auf der ersten Kontaktträgerplatte (20) an ihren vier Ecken je eine Führungseinheit (8) befestigt ist, die jweils aus einem Führungsstift (23) besteht, der durch eine in der Andruckplatte (9) befindlichen Buchse (24) geführt ist, und der an seinem oberen Ende eine mit einer Handschraube (28) gesicherte Führungshülse (25) mit Außenkonus enthält, die mittels einer an der Andruckplatte (9) abestützten Gegendruckfeder (27) nach oben gedrückt wird, daß fluchtend zum Führungsstift (23) in der zweiten Kontaktträgerplatte (4) ein Führungsflansch (26) befestigt ist, der beim Schließen mit seinem Innenkonus in den Außenkonus der Führungsstifte (25) eingreift.

5. Vakuumadapter zum Kontaktieren von zu prüfenden Elektronikflachbaugruppen mit einer Prüfeinrichtung nach Anspruch 4,
**dadurch gekennzeichnet,**
daß auf der zweiten Kontaktträgerplatte (4) Führungsdeckel (29) angeordnet sind, die Ausnehmungen (35) enthalten, in die der Führungsstift (23) nach dem Schließvorgang einfährt.
